# EUROPEAN PATENT APPLICATION

(11) **EP 4 072 255 A1**
(43) Date of publication of application: **12.10.2022**
(21) Application number: 21167581.4
(22) Date of filing: 09.04.2021
(51) Int. Cl.: H05K 7/20, G06F 1/20

(54) **COOLING SYSTEMS AND HEAT EXCHANGERS**

(71) Applicant: Accelsius, LLC, Austin TX 78757 (US)
(72) Inventor: Enright, Ryan, New Jersey, 07974 (US); Amalfi, Raffaele Luca, New Jersey, 07974 (US); Kafantaris, Vasileios, 14564 Nea Kifisia (GR)
(74) Representative: Hoffmann Eitle

(57) **Abstract**

Examples of the disclosure relate to a cooling system for cooling one or more electronic components. The cooling system comprises at least one two-phase cooling system configured to cool one or more electronic components that are thermally coupled to the at least one two-phase cooling system and at least one air-cooling system configured to cool one or more electronic components. The at least one air-cooling system comprises at least one heat exchanger within the at least one air-cooling system wherein the at least one heat exchanger is coupled to a two-phase cooling system or a liquid phase cooling system. The at least one air-cooling system also comprises recirculation means configured to re-circulate air through the at least one air-cooling system to the one or more electronic components.

## Description

### TECHNOLOGICAL FIELD

Examples of the disclosure relate to cooling systems and heat exchangers. The cooling systems and heat exchangers can be applicable to vertical optical connectivity servers as well as to pluggable optical interconnects (arrays) for network routing applications, and to vertical servers for different applications. Some examples of the disclosure relate to evaporators and heat exchangers as part of cooling systems for data centres comprising a plurality of electronic devices such as servers and other hardware components.

### BACKGROUND

Cooling is used to enable telecommunications and computing systems to function properly. Efficient cooling systems that consume less energy, reduce any active control, provide easy serviceability and lower costs are therefore advantageous.

### BRIEF SUMMARY

According to various, but not necessarily all, examples of the disclosure there is provided a cooling system for cooling one or more electronic components comprising:
at least one two-phase cooling system configured to cool one or more electronic components that are thermally coupled to the at least one two-phase cooling system;
at least one air-cooling system configured to cool one or more electronic components wherein the at least one air-cooling system comprises at least one heat exchanger within the at least one air-cooling system wherein the at least one heat exchanger is coupled to a two-phase cooling system or a liquid phase cooling system; and recirculation means configured to re-circulate air through the at least one air-cooling system to the one or more electronic components.

The recirculation means may comprise at least one fan configured to direct the air back into the at least one air-cooling system and prevent air from being expelled from the at least one air-cooling system.

The at least one air-cooling system may comprise one or more baffles configured to direct air from the air-cooling system toward electronic components that are not cooled by the at least one two-phase cooling system.

The air-cooling system may comprise one or more baffles configured to direct air from the air-cooling system towards the at least one two-phase cooling system.

The at least one heat exchanger within the at least one air-cooling system may comprise at least one evaporator.

The cooling system may comprise a plurality of two-phase cooling systems configured in a cascading configuration to enable cooling of a plurality of electronic components.

The at least one two-phase cooling system may be configured to reject heat to a secondary cooling system.

The cooling system may comprise one or more thermal connections between the electronic components and the at least one two-phase cooling system.

The apparatus may comprise a monolithic evaporator configured to thermally couple a plurality of electronic components to the at least one two-phase cooling system.

The apparatus may comprise a plurality of evaporators configured to thermally couple a plurality of electronic components to the at least one two-phase cooling system.

The at least one two-phase cooling system may comprise one or more oscillating heat pipe.

The one or more oscillating heat pipes may be configured to enable heat to be transferred from one or more electronic components to another two-phase cooling system.

The at least one two-phase cooling system may comprise a thermosyphon loop.

The at least one two-phase cooling system may comprise one or more structures having a surface area configured to provide efficient heat transfer.

The cooling system may comprise one or more thermal connections between the electronic components and the at least one two-phase cooling system.

The plurality of electronic components may be provided within a server.

The at least one electronic component may be configured to be cooled by the at least one two-phase cooling system is configured to be removably connected to the server.

The plurality of electronic components may comprise one or more optoelectronic components.

According to various, but not necessarily all, examples of the disclosure there may be provided a server comprising one or more cooling systems as described herein.

### BRIEF DESCRIPTION

Some examples will now be described with reference to the accompanying drawings in which:
FIG. 1 shows a schematic example two-phase cooling system;
FIG. 2 shows an example two-phase cooling system;
FIG. 3 shows another example two- phase cooling system;
FIGS. 4A to 4C show further schematic example cooling systems;
FIG. 5 shows another example cooling system;
FIG. 6 shows a cross section of some components of a cooling system;
FIG. 7 shows a plot of thermal resistance for different thermal interface materials;
FIG. 8 show a plurality of views of part of an example cooling system;
FIG. 9 show a plurality of views of part of an example cooling system;
FIG. 10 shows a schematic oscillating heat pipe cooling system;
FIG. 11 shows another schematic oscillating heat pipe;
FIG. 12 shows example rack-level telecom equipment;
FIG. 13 shows an example cooling system for a plurality of racks; and
FIG. 14 shows another example cooling system fora plurality of racks.

### DETAILED DESCRIPTION

Examples of the disclosure relate to cooling systems that can be used to cool electronic components. The electronic components can be provided in servers or in any other suitable devices or arrangements. In examples of the disclosure a first cooling system is configured to cool electronic components that generate large amounts of heat such as opto-electronic components. The first cooling system enables the heat to be efficiently removed from the electronic components and rejected to the outside environment. A second cooling system is configured to cool any other components within the servers or other devices. The second cooling system can be a liquid-cooling or a two-phase cooling system that uses supplemental air-cooling. The air flow can be configured so that the coolant air flow can be recirculated within the servers or other devices. This prevents hot air from being expelled into the environment around the cooling systems and electronic devices.

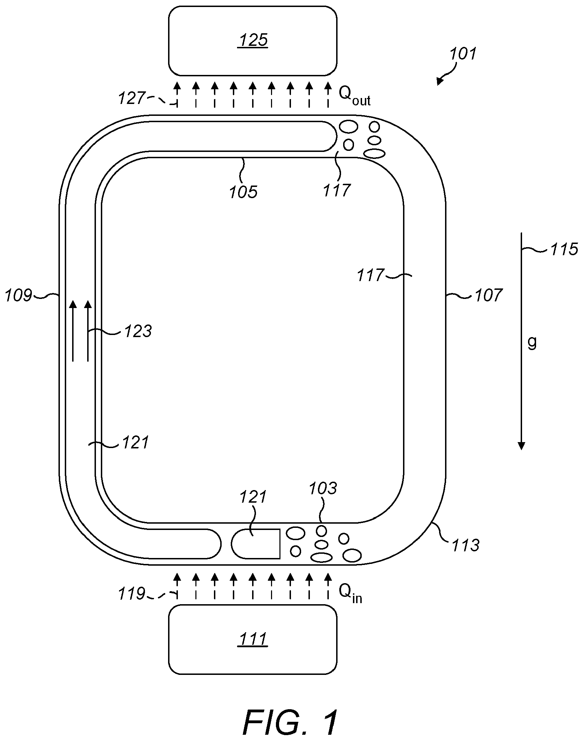

Fig. 1 shows a schematic example two-phase cooling system 101 that can be used in examples of the disclosure. In the example of Fig. 1 the two-phase cooling system 101 comprises a thermosyphon loop that is driven by gravity rather than a pump.

The thermosyphon loop shown in Fig. 1 comprises an evaporator 103, a condenser 105, a downcomer 107 and a riser 109. A working fluid 113 is provided within the thermosyphon loop. When the thermosyphon loop is in use the working fluid 113 circulates through the components of the thermosyphon loop.

The evaporator 103 is provided at the bottom of the thermosyphon loop so that the working fluid flows down the downcomer 107 into the evaporator 103 under the force of gravity as indicated by the arrow 115. The height of the thermosyphon loop 101 and inner diameters of the downcomer 107 and riser 109 can be selected to set the driving force that causes the fluid to flow through the evaporator 103, riser 109 and condenser 105. The working fluid 113 is in the liquid phase 117 at the inlet of the evaporator 103.

The evaporator 103 comprises any means for transferring heat from a heat source 111 into the working fluid 113. The heat source 111 can be a single electronic component or a plurality of electronic components dissipating the heat into the evaporator 103. The evaporator 103 is thermally coupled to the heat source 111. A thermal interface material could be used to enable the evaporator 103 to be thermally coupled to the heat source 111. The heat source 111 could comprise an electronic component that generates unwanted heat during operation. The electronic component could be part of a server, router, network switch, telecom board, storage device or any other suitable type of device. In some examples a plurality of servers and/or other devices can be configured to provide a data centre, telecommunication equipment room, or network, a communication room, a computer room, a network room or any other suitable arrangement.

Heat is transferred from the heat source 111 to the working fluid 113 in the evaporator 103 as indicated by the arrows 119. This heat transfer causes a partial evaporation of working fluid 113 within the evaporator 103 and converts the working fluid 113 from a liquid phase 117 into a mixture of liquid 117 and vapour phase 121. The evaporator 103 causes some of the working fluid 113 to be converted into the vapour phase 121 while some remains in a liquid phase 117 so that the fluid expelled from the outlet of the evaporator 103 is a two-phase mixture. The heat transfer in the evaporator 103 is a combination of sensible and latent heat accounting for the subcooled heat transfer and saturated boiling heat transfer. The mass fraction of vapor 121 at the outlet of the evaporator 103 is identified by the vapor quality that is calculated as the ratio between the mass of the vapor 121 divided by the mass of the working fluid 113. The two-phase mixture can comprise droplets of vapour entrained within the liquid, liquid slugs and vapor plugs or other flow regimes depending on the design of the thermosyphon loop, heat load, filling ratio, working fluid and any other suitable parameter.

The evaporator 103 is coupled to the riser 109 so that the working fluid expelled from the evaporator 103 flows into the riser 109. This working fluid comprises a two-phase mixture where the vapour phase 121 is less dense than the liquid phase 117. The working fluid 113 within the thermosyphon loop rises through the riser 109, as indicated by the arrows 123. The passive flow in the thermosyphon loop is driven by the density difference between the working fluid 113 in the liquid phase in the downcomer 107 and the working fluid 113 in the two-phase mixture in the riser 109. Depending on the operating conditions, the liquid phase can fully or partially occupy the available volume of the downcomer 107.

The evaporator 103 can comprise structures that enable efficient transfer from the evaporator 103 into the working fluid 113. For example, the evaporator 103 could comprise wick structures, micro-channels, arrays of evaporator fins, a serpentine arrangement of macro- / micro-channels or any suitable combination of such features.

The condenser 105 is provided at the top of the thermosyphon loop. The condenser 105 is positioned above the evaporator 103 so that the working fluid 113 flows upwards from the evaporator 103 to the condenser 105.

The condenser 105 is coupled to the riser 109 so that the working fluid 113 in the two-phase mixture (vapour phase 121 and liquid phase 117) flows from the riser 109 into the condenser 105. The condenser 105 can comprise any means for cooling the working fluid 113. For example, the condenser 105 could be air-cooled or liquid-cooled. A liquid-cooled condenser 105 could comprise a tube-in-tube heat exchanger, a shell- and-tube heat exchanger, a plate heat exchanger or any other suitable heat exchanger configuration or arrangement. An air-cooled condenser could comprise a louvered-fin flat tube heat exchanger, a tube-and-fin heat exchanger or any other suitable heat exchanger configuration or arrangement. The condenser 105 can comprise any suitable geometry that enables heat to be removed efficiently from the working fluid.

The condenser 105 is thermally coupled to a coolant 125. A thermal interface material could be used to enable the condenser 105 to be thermally coupled to the coolant 125. The latter implementation can be also used to enable hardware hot-swappability by installing a reworkable thermal interface material that connects the two streams of the condenser 105. In other examples the coolant 125 can be directly integrated in the condenser 105 with a wall interface separating the stream of thermosyphon working fluid 113 from the stream of coolant 125. The wall interface can comprise a highly-conductive metal or metal alloy, such as copper, aluminum, brass, or any other suitable metal.

The condenser 105 enables heat to be transferred from the working fluid 113 to the coolant 125 as indicated by the arrows 127. This heat transfer causes the working fluid 113 to condense, at least partly, back into the liquid phase 117. The working fluid 113 at the outlet of the condenser 105 can be therefore in the liquid phase 117 or in the two-phase mixture (vapour phase 121 and liquid phase 117).

The condenser 105 is coupled to the downcomer 107 so that the working fluid 113 can flow down the downcomer 107 by gravity and be returned to the inlet of the evaporator 103 to start the cycle again.

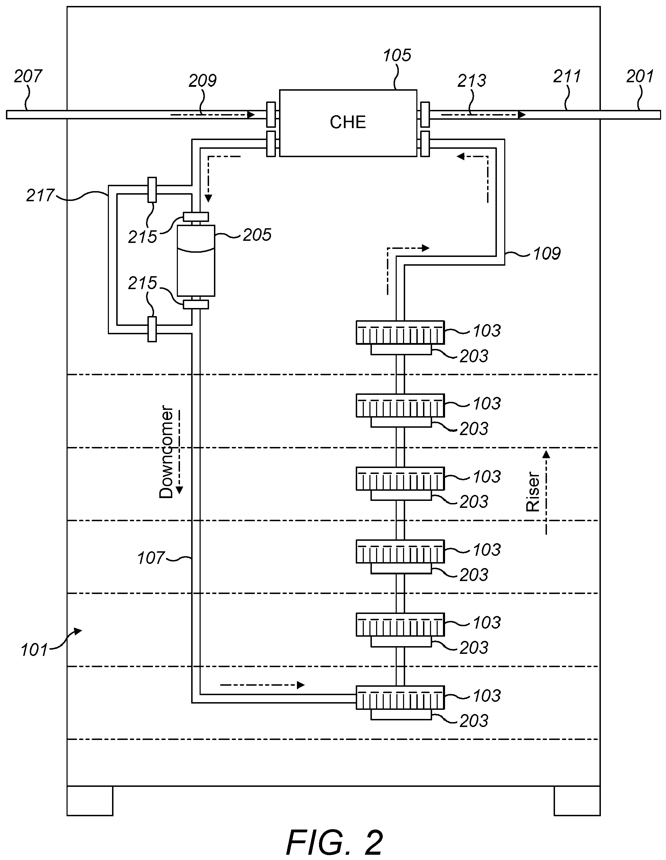

Fig. 2 shows an example two-phase cooling system 101. In this example the two-phase cooling system 101 comprises a thermosyphon loop that can be configured to enable cooling of a plurality of electronic components 203 in a rack or any other suitable device or arrangement.

In the example of Fig. 2 the thermosyphon loop comprises a plurality of evaporators 103 where each of the evaporators 103 is thermally coupled to an electronic component 203 that generates unwanted heat during use. The electronic component 203 could be an opto-electronic component or any other suitable type of component. The electronic component 203 could be part of a server or any other suitable device. In some examples the electronic components 203 can comprises hot-swappable components. These are components that can be extracted from, or inserted into, the device while the device is in use.

The evaporators 103 are coupled to the electronic components 203 to enable heat transfer (removal) from the electronic components 203 causing the working fluid in the evaporators 103 to be evaporated. Six electronic components 203 and corresponding evaporators 103 are shown in the thermosyphon loop of Fig. 2, however it is to be appreciated that other numbers of electronic components 203 and evaporators 103 could be used in other examples of the disclosure.

In the example shown in Fig. 2 the evaporators 103 are arranged in series within the thermosyphon loop so that working fluid expelled from a first evaporator 103 is then provided to the inlet of the next evaporator 103 within the series. In this series arrangement the working fluid passes through each of evaporators 103 sequentially. As the working fluid passes through the evaporators 103 the mass fraction of the vapour phase increases, as more heat is absorbed during the evaporation process.

The example thermosyphon loop of Fig. 2 comprises an accumulator 205 in the downcomer 107. The accumulator 205 can be a liquid accumulator or a receiver. The accumulator 205 can comprise any means that can be configured to store working fluid. The working fluid inside the accumulator 205 can comprise a portion of liquid and the remaining volume will be a two-phase mixture in saturated condition. The accumulator 205 helps to prevent the working fluid in the liquid phase from entering the condenser 105 due to the larger cross sectional-area of the accumulator 205 relative to the downcomer 107. This avoids flooding of the condenser 105 that could result in a decrease in thermal performance of the thermosyphon loop.

In the example of Fig. 2 the accumulator 205 is coupled to the downcomer 107 by one or more quick couplings 215 and/or isolation valves. This can enable the accumulator 205 to be removed from the thermosyphon loop. The quick couplings 215 and/or isolation valves can be arranged with one or more bypass lines 217. The bypass lines 217 can be configured to enable continuous cooling during the removal/maintenance of the accumulator 205.

In this example the condenser 105 comprises a compact heat exchanger. Other types of condenser 105 could be used in other examples of the disclosure. The type of condenser 105 that is used can be selected based on the expected amount of heat that is to be removed from the thermosyphon loop. This can be dependent upon the number of electronic components 203 that are to be cooled by the thermosyphon loop.

In the example shown in Fig. 2 a secondary cooling system 201 is coupled to the condenser 105 to enable heat to be transferred out of the thermosyphon loop and away from the electronic components 203 and equipment housing space such as data center, telecommunication equipment room, or network, a communication room, a computer room, a network room, indoor or outdoor deployed cabinet/s or any other suitable arrangement. In this example water is the coolant and is provided at an inlet 207 as indicated by the arrow 209. The condenser 105 is configured so that heat is then transferred from the working fluid of the thermosyphon loop to the water of the secondary cooling system 201. The heated water is then expelled from the outlet 211 as indicated by the arrow 213. In other examples the secondary cooling system 201 could use a different working fluid. For example, this can be a dielectric fluid that is boiling during the heat transfer process and so the heat exchanger would operate in condensation-to-evaporation mode. In other examples the secondary cooling system could be another two-phase cooling system. In some examples, the secondary cooling system 201 can be pumped or passively driven by gravity with a rooftop heat exchanger. Other implementations can comprise the condenser 105 to be installed, not necessarily above each individual rack, but in other convenient locations within the room with piping connecting different racks to the common condenser 105. Due to the passive nature of the two-phase cooling system, there is the need to have a certain height between the condenser 105 and electronic components 203. The arrangements here presented could enable a plurality of two-phase cooling systems to be provided in a cascading arrangement to enable heat to be transferred away from the electronic components 203.

In the example shown in Fig. 2 the condenser 105 has a counter-flow arrangement where the inlets for the working fluid and the water are located on opposite sides of the condenser 105. In other examples the condenser 105 can be configured to have a parallel-flow arrangement, a cross-flow arrangement or any other suitable type of arrangement.

In the example shown in Fig. 2 only a part of the secondary cooling system 201 is shown. The secondary cooling system 201 could be an active or passive cooling system , or any other suitable type of cooling system.

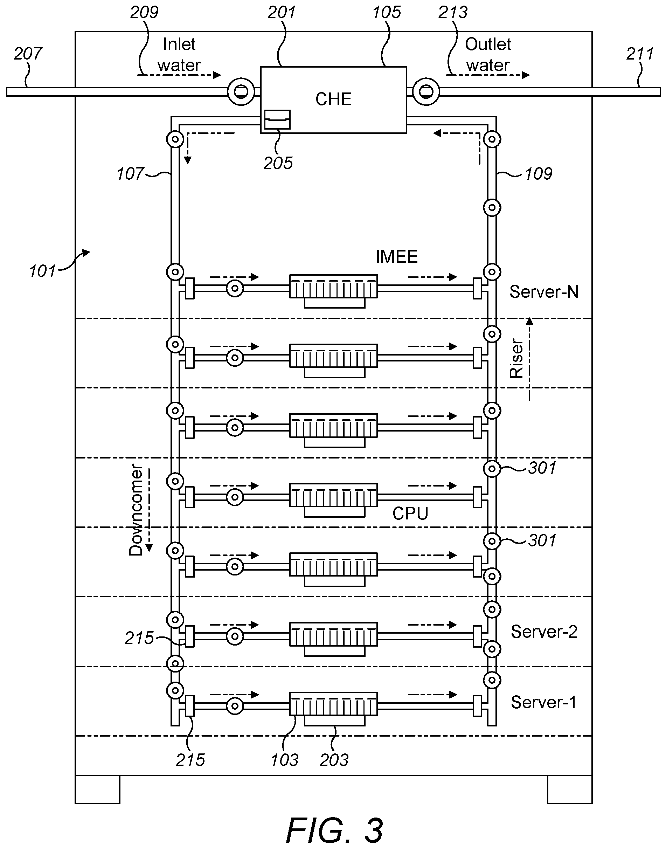

Fig. 3 shows another example two-phase cooling system 101. In this example the two-phase cooling system 101 comprises another thermosyphon loop that can be configured to enable cooling of a plurality of electronic components 203 in a server or any other suitable device or arrangement similar to the two-phase cooling system 101 as shown in Fig. 2. However, in the example shown in Fig. 3 the plurality of evaporators 103 of the thermosyphon loop are arranged in parallel rather than in series.

The two-phase cooling system 101 of Fig. 3 comprises seven evaporators 103 configured to cool seven electronic components 203. It is to be appreciated that other numbers of electronic components 203 and evaporators 103 could be used in other examples of the disclosure. The downcomer 107 comprises a branched manifold to provide different inlets for each of the evaporators 103. Each of the outlets of the evaporators 103 is provided to the riser 109. During operation of the thermosyphon loop 101, the working fluid 113 is divided among the number of electronic components to be cooled according to the parallel arrangement.

The example apparatus 201 of Fig. 3 also comprises an accumulator 205 in the downcomer 107. The accumulator 205 can comprise any means that can be configured to store working fluid 113. The accumulator 205 is positioned between the outlet of the condenser 105 and the inlet for the first evaporator 103.

The condenser 105 in the example of Fig. 3 also comprises a compact heat exchanger. Other types of condenser 105 could be used in other examples of the disclosure. A secondary cooling system 201 is coupled to the condenser 105 to enable heat to be transferred out of the thermosyphon loop 101. As in the example shown in Fig. 2 water is the coolant and it is provided at the inlet 207 as indicated by the arrow 209. The condenser 105 is configured so that heat is then transferred from the working fluid of the thermosyphon loop to the water of the secondary cooling system 201. The heated water is then expelled from the outlet 211 as indicated by the arrow 213.

The two-phase cooling system 101 in the example of Fig. 3 also comprises a plurality of sensors 301. The sensors 301 are positioned within the two-phase cooling system 101 and can be used to obtain measurements of parameters of the working fluid within the two-phase cooling system 101. The parameters that are monitored can relate to the efficiency of the two-phase cooling system 101 and the amount of heat being transferred by the two-phase cooling system 101. The parameters that can be monitored using the sensors 301 can comprise vapour quality, mass flow rate, pressure, temperature or any other suitable parameter or combination of parameters. The information obtained using the one or more sensors 301 can be used to control or otherwise monitor the performance of the two-phase cooling system 101.

In the example of Fig. 3 quick couplings 215 are provided in the outlets and inlets of the evaporators 103. These enable the evaporators 103 to be removed from the two-phase cooling system 101 enabling the hot-swappability of the electronic components 203. This enables the electronic components 203 to be removed and/or replaced while the two-phase cooling system is in use.

In the examples shown in Figs. 2 and 3 the secondary cooling system is a water-cooled system. In other examples the secondary cooling system could be an air-cooled system, a liquid-cooled system, a two-phase cooling system or any other suitable cooling means, arrangements and configurations.

In the examples shown in Figs. 1 to 3 the two-phase cooling system 101 comprises a passive thermosyphon loop. It is to be appreciated that other types of single-phase and two-phase cooling system 101 could be used in other examples of the disclosure. For instance, in some examples the two-phase cooling system 101 could comprise an active two-phase cooling system 101 comprising one or more pumps that are configured to pump working fluid needed for the cooling of the electronic components 203.. In this case, the condenser 105 can be installed anywhere, as the cooling system does not rely on the passive flow circulation.

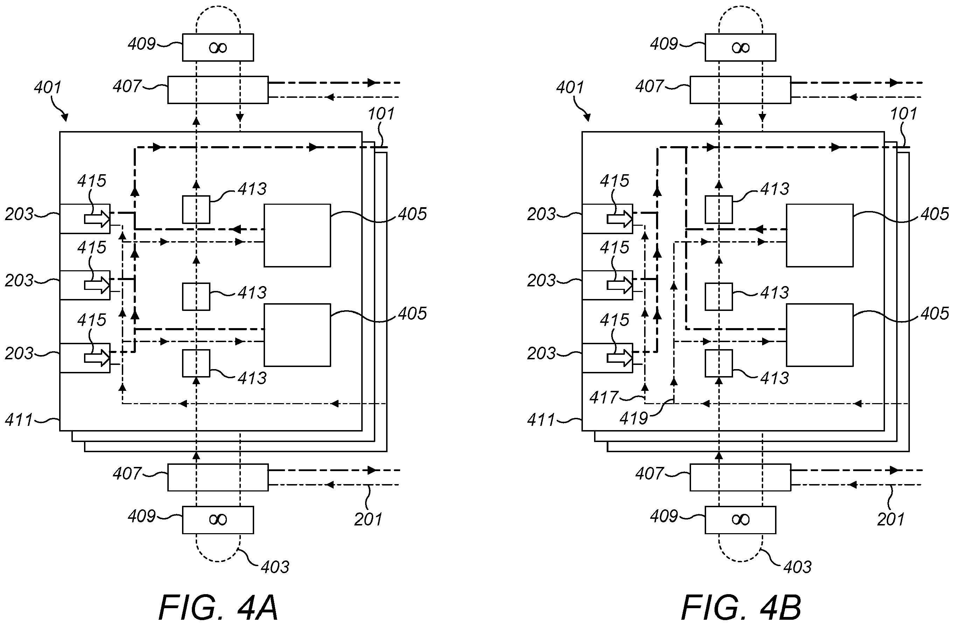

Figs. 4A to 4C schematically show example cooling systems 401 for cooling a plurality of electronic components 203, 405, 413 according to examples of the disclosure. The example cooling systems 401 comprise a first two-phase cooling system 101 for high heat generating electronics components 203, 405 and a second air-cooling system 403 for low heat generating electronic components 413.

The electronic components 203, 405, 413 can be provided as part of a server rack or any other suitable device. The electronic components 203, 405, 413 can comprise opto-electronic components, CPUs (central processing units), hardware accelerators, or any other suitable components. The electronic components 203, 405, 413 can be provided on a server board 411 or in any other suitable configuration. The electronic components 203, 405, 413 can be provided as part of different hardware such as blade servers or vertical optical connectivity server or pluggable optical interconnects (arrays) for network routing applications or any other suitable type of hardware.

In the examples shown in Figs. 4A to 4C the server board 411 comprises a plurality of replaceable pluggable electronic components 203. These are provided at the edge of the server board 411 to allow for replacement of these components. The pluggable electronic components 203 can be high heat generating components such as optical interconnects or any other suitable type of component. The pluggable electronic components 203 can comprise hot swappable components within the server. These are components that can be removed and/or inserted into the server while the server is in use.

The server board 411 also comprises additional high heat generating components 405. These can comprise CPUs or any other suitable type of component that can generate high levels of heat during use. The high heat generating components 405 can be located in any suitable location within the server board 411. The high heat generating components 405 can be located in different positions to the pluggable components 203 or other main sources of heat on the server board 411.

The server board 411 also comprises a plurality of low heat generating components 413. These low heat generating components 413 can have different form factors than the high-heat generating components 405 and generate low levels of heat compared to the high heat generating components 203, 405. These low heat generating components 413 could comprise one or more memories or any other suitable components. The low heat generating components 413 can be positioned in any suitable location within the server board 411.

Fig. 4A shows a cooling system 401 comprising a two-phase cooling system 101 for cooling a first sub-set of electronic components 203, 405 and an air-cooling system 403 for cooling a second subset of electronic components 413. In the example of Fig. 4A the two-phase cooling system 101 cools the high-heat generating components 203, 405 and the air-cooling system cools the low-heat generating components 413.

The first subset of the electronic components 203, 405 are thermally coupled to at least one two-phase cooling system 101 so that a thermal connection is provided between the electronic components 203, 405 and the two-phase cooling system 101. The electronic components 203, 405 can be thermally coupled to the two-phase cooling system 101 to enable heat to be transferred from the electronic components 203, 405 to the working fluid 113 in the two-phase cooling system 101 as indicated by the arrows 415.

It is to be appreciated that only part of the two-phase cooling system 101 is provided on the server board 411 and shown in Fig. 4A. In this example the evaporator sections are coupled to the electronic components 203, 405 and so are provided on the server board 411. The downcomer 107 and the riser 109 can then extend away from the server board 411 to one or more condensers 105 that can be located in any suitable location.

A physical interface can be provided between the electronic components 203, 405 and the two-phase cooling system 101. The physical interface can comprise a thermal interface material or any other suitable components. The physical interface can also comprise a thermal connection, such as a latch mechanism, that provides efficient heat transfer from the electronic components 203, 405 to the two-phase cooling system 101.

The evaporator 103 of the two-phase cooling system 101 can comprise one or more structures that provide efficient heat transfer from the electronic components 203, 405 into the working fluid 113. For example, the evaporator 103 can comprise structures that provide a large surface area for efficient heat transfer. The structures could comprise a flat, low profile tubing, finned structures or any other suitable structures.

The two-phase cooling system 101 can be configured to reject heat to a secondary cooling system. The secondary cooling system can be as shown in Figs. 2 and 3 or could comprise any other suitable type of secondary cooling system 201. The secondary cooling system can be air-cooled, liquid cooled or two-phase cooled.

The air-cooling system 403 can be configured to cool a second subset of electronic components 413. The second subset of electronic components 413 can comprise the low heat generating components 413. The low heat generating components 413 are not thermally coupled to the two-phase cooling system 101. The transfer of heat from the air-cooled electronic components 413 to the two-phase cooling system 101 is via convective air heat transfer to heat exchanger 407 at the server level.

The air-cooling system 403 comprises at least one heat exchanger 407. In this example the heat exchangers 407 comprise at least one evaporator. The evaporator can comprise any means that enables heat to be transferred out of, and thus to cool the air. For example, the evaporator can comprise an air finned-tube evaporator or any other suitable means, arrangements, configurations.

The heat exchangers 407 can be connected to a secondary cooling system 201(passive two phase cooling system, liquid cooled system or else) to reject the heat transferred out of the air in the air-cooling system 403. In the example of Fig. 4A the secondary cooling system 201 can be a thermosyphon loop or any other suitable type of cooling system.

The heat exchangers 407 can be positioned in any suitable location around the server board 411. For instance, where the cooling system 401 is provided in a vertical server, the heat exchangers 407 can be provided at the top and bottom of the server slots.

The air-cooling system 403 also comprises recirculation means 409 configured to re-circulate air through the one air-cooling system 403. In the example of Fig. 4A the recirculation means 409 can comprise one or more fans configured to direct the air from the heat exchangers 407 back into the air-cooling system 403. The recirculation means 409 can be configured to prevent air from being expelled from at least one air cooling system 409. This can help to prevent heating of the environment around the server 411, thus not interfering from thermal management point of view with equipment housing space such as data center, telecommunication equipment room, or network, a communication room, a computer room, a network room, indoor or outdoor deployed cabinet/s or any other suitable arrangement.

The air-cooling system 403 can be configured to enable the air to be circulated through a plurality of different server boards 411. For example, a plurality of server boards 411 could be provided within a server rack and the air-cooling system could be configured to control the flow of air across the plurality of server boards 411. A plurality of server boards 411 are shown in a stacked arrangement in Fig. 4A. In such examples the recirculation means can be configured to retain the air within the server rack and prevent the air from being expelled from the server rack.

Fig. 4B shows another example cooling system 401 comprising a two-phase cooling system 101 for cooling a first sub-set of electronic components 203, 405 and an air-cooling system 403 for cooling a second subset of electronic components 413. In this example the air-cooling system 403 can be as shown in Fig. 4A and described above.

The two-phase cooling system 101 shown in Fig. 4B differs from the two-phase cooling system shown in Fig. 4A in that the evaporator in Fig. 4B comprises a split-flow manifold. This allows for a first evaporator manifold 417 that provides working fluid for the pluggable components 203 and a second evaporator manifold 419 that provides working fluid for the other high-heat generating components 405. Other arrangements for the two-phase cooling system 101 could be used in other examples of the disclosure.

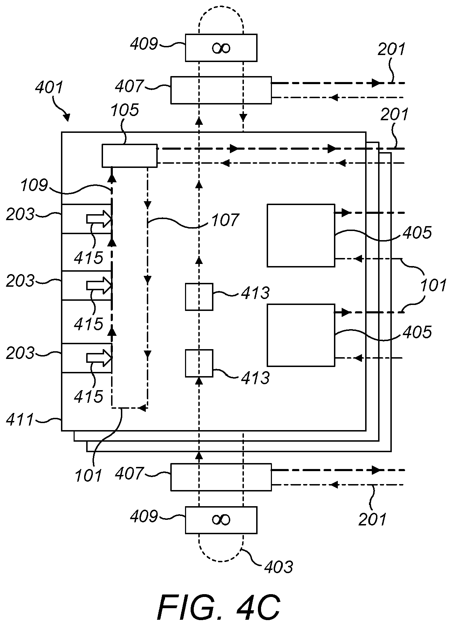

Fig. 4C shows another example cooling system 401 comprising a two-phase cooling system 101 for cooling a first sub-set of electronic components 203, 405 and an air-cooling system 403 for cooling a second subset of electronic components 413. In this example the air-cooling system 403 can be as shown in Fig. 4A and described above.

The two-phase cooling system 101 shown in Fig. 4C differs from the two-phase cooling system 101 shown in Fig. 4A in that in Fig. 4C a complete two-phase cooling system 101 is provided on the server board 411. That is, the evaporator 103, condenser, downcomer 107 and riser 109 are all provided on the same server board 411. A secondary two-phase cooling system 201 is then thermally coupled to the condenser 105 to allow for the removal of heat from the primary two-phase cooling system 101. This can allow for a cascading arrangement of two-phase cooling systems 101. A separate two-phase cooling system 101 is provided for the other high heat generating components 405.

The air-cooling system 403 in the examples shown in Figs. 4A to 4C therefore provides supplementary cooling for the server board 411. The two-phase cooling system 101 can be configured to transfer heat from electronic components 203, 405 such as optoelectronic components that can generate significant amounts of heat. The air-cooling system 403 can provide supplemental or auxiliary cooling for low-heat generating components 413.

In some examples the air-cooling system 403 can comprise additional components that are not shown in Fig. 4. For instance, in some examples the air-cooling system 403 can comprise one or more baffles configured to direct the flow of air across the server board 411.

In some examples the baffles can be configured to direct air from the air-cooling system 403 toward electronic components 413 that are not cooled by the two-phase cooling system 101. This can help to ensure that sufficient cooling is provided for the air-cooled electronic components 413.

In the examples shown in Figs. 4A to 4C the pluggable components 203 are provided in a vertical arrangement. It is to be appreciated that the pluggable components 203 could also be provided in a horizontal arrangement or in any other suitable configuration.

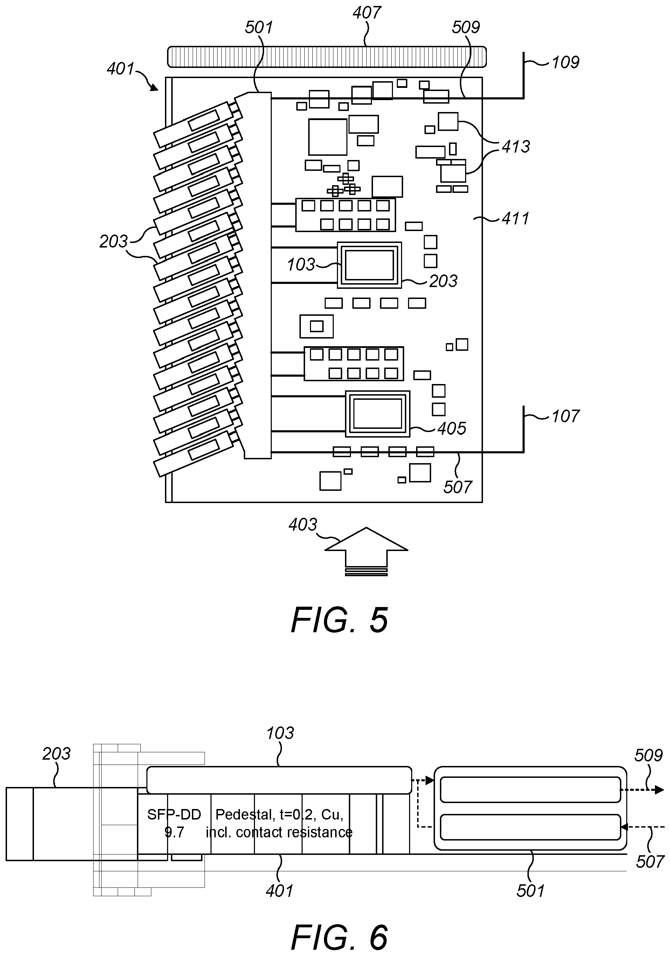

Fig. 5 schematically shows another example arrangement of a cooling system 401 that can be used in some examples of the disclosure. The cooling system 401 is configured to cool electronic components 203 and 405 that are provided on a server board 411. In this example the server board 411 is part of a vertical server rack. The cooling system 401 comprises a two-phase cooling system 101 and an air-cooling system 403. The two-phase cooling system 101 is configured to cool a plurality of high heat generating electronic components 203, 405 such as the pluggable components 203 that can be removable connected to the server board 411 while the server is in use, the CPU components 405 and any other suitable components. The air-cooling system 403 can be configured to cool a plurality of low heat generating components 413 on the server board 411.

In the example of Fig. 5 the evaporator 103 of the two-phase cooling system 101 comprises a split-flow manifold 501 (see details in Fig.6). The split flow manifold 501 extends between a horizontal inlet manifold 507 and a horizontal outlet manifold 509. The horizontal inlet manifold 507 is coupled to the downcomer 107 of the two-phase cooling system 101, so that working fluid 113 in the liquid phase flows from the downcomer 107 into the horizontal inlet manifold 507 and into the split flow manifold 501.

The split-flow manifold 501 is configured to distribute the working fluid 113 from the downcomer 107 to a plurality of evaporators 103 that are thermally coupled to the electronic components 203, 405. The evaporators 103 can comprise rider evaporators 103 as shown in Fig. 6.

The horizontal outlet manifold 509 is coupled to the riser 109 of the two-phase cooling system 101 so that the two-phase working fluid can flow from the split-flow manifold 501 to the riser 109 via the horizontal outlet manifold 509. The fluid flows through the riser to the condenser 105 which is not shown in Fig. 5.

The air-cooling system 403 comprises a heat exchanger 407 that is provided at the top of the server board 411. In this example the heat exchanger 407 can comprise a finned-tube heat exchanger that is configured to enable heat from the air to be transferred into a refrigerant in a secondary cooling system. The air that has been cooled by the heat exchanger 407 can then be recirculated back to the bottom of the server board 411 as indicated by the arrow 507. Any suitable recirculation means can be used to enable for the recirculation of the air. For example, one or more fans or other means for directing air flow can be used.

The cooled air can then be directed over the low heat generating electronic components 413. These electronic components 413 can comprise one or more electronic components that are not cooled by the two-phase cooling system 101. In the example of Fig. 5 these electronic components 413 can comprise one or more memories or any other suitable components.

In the example of Fig. 5 high heat generating components 203, 405 are also coupled to evaporators 103 that are fluidically coupled to the split-level manifold 501. This can enable some of the other electronic components that are not part of the array of interchangeable components to be cooled by the two-phase cooling system 101.

In the example of Fig. 5 a downcomer 107 and riser 109 provide working fluid 113 for the two-phase cooling system 101. In some examples a quick coupling could be provided in the downcomer 107 and the riser 109. This can enable one or more of the electronic components 203 to be removed while the other electronic components 203, 405 413 on the server bord 411 remain operational.

In some examples the cooling system 401 can be configured to enable the cooling system 401 to be retrofitted to existing server boards 411. For instance, existing server boards 411 where the electronic components 203 are cooled by air-cooled heat sinks could be modified by removing the air-cooled heat sinks and providing a thermal connection to the split-level manifold 501.

In examples of the disclosure the two-phase cooling system 101 can be configured to remove most of the unwanted heat from the server board 411. In experiments the two-phase cooling system 101 has been shown to remove almost 80% of the unwanted heat leaving the air-cooling system 403 to remove around 20%. This reduces the amount of heat that is rejected into the air-cooling system 403. This enables the air of the air-cooling system 403 to be efficiently cooled by a secondary cooling system so that the air can be recirculated back into the server board 411 rather than being rejected into the environment around the server board 411, while keeping a reduced form factor for the heat exchanger 407. This enables the servers, or other devices, that use cooling systems 401 according to examples of the disclosure, to be positioned in any convenient locations without interfering from thermal management point of view with equipment housing space such as data center, telecommunication equipment room, or network, a communication room, a computer room, a network room, indoor or outdoor deployed cabinet/s or any other suitable arrangement.

Fig. 6 shows a cross section of components of an example cooling system 401. Fig. 6 shows part of an electronic component 203 and an evaporator 103 thermally coupled to the electronic components 203 and the split-level manifold 501. These could be parts of the cooling system 401 as shown in Fig. 5.

The electronic component 203 is mounted on the server board 411. The evaporator 103 is provided in thermal connection with the electronic components 203. The evaporator 103 can be a rider evaporator 103. Each electronic component 203 within the server board 411 can be coupled to a different evaporator 103. This can enable removal and reconnection of individual electronic components 203 as needed.

The evaporator 103 is fluidically connected to the split-level manifold 501. This enables working fluid 113 to flow between the split-level manifold 501 and the evaporators 103. The fluidic connections can be flexible to allow for manufacturing tolerances in the building and assembly of the electronic components 203 and the server board 411.

The evaporators 103 that are used for transferring heat to the two-phase cooling system 101 can be smaller than evaporators that would be needed to transfer heat to an air-cooling system. This can allow for a more compact design of the server board 411 and can allow for more electronic components 203 to be provided on the server board 411 and/or can allow for higher power electronic components 203 to be used.

In some examples the server board 411 can comprise a cage into which the electronic components 203, or a subset of the electronic components 203 can be fitted. In such cases the evaporator 103 can be sized and shaped so that the electronic components 203 and the evaporators 103 can be retrofitted into existing cages.

In some examples a thermal interface material (TIM) can be provided between the electronic components 203 and the evaporator 103 to enable the electronic components 203 to be inserted and removed from the server board 411.

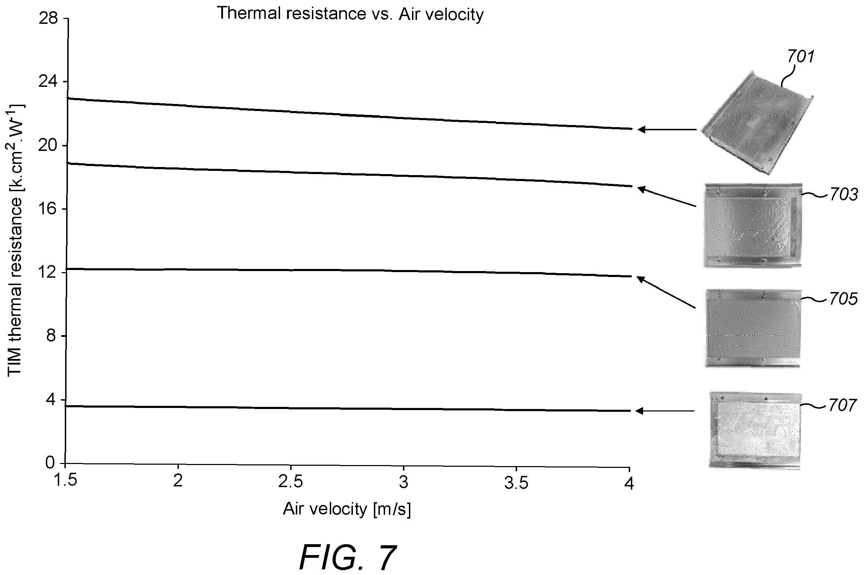

Fig. 7 shows a plot of thermal resistance for different thermal interface materials as a function of air velocity. The thermal interface material could be used between the electronic components 203 and the evaporators 103. Plot 701 shows the thermal resistance with no TIM, plot 703 shows the thermal resistance for a 3M TIM, plot 705 shows the thermal resistance for a Chomerics TIM and plot 707 shows the thermal resistance for a liquid metal alloy TIM.

The plots of Fig. 7 show that the thermal resistance is approximately constant with air speed and that a phase change-based TIM provides the lowest thermal resistance.

The plots of Fig. 7 shows that thermal interface resistance values of 3.6 ≤ R ≤ 23 K.cm²/W can be expected depending on the type of TIM that is used. If the electronic components 203 cannot exceed a temperature of 70 °C and they have a maximum power dissipation of 1.33 W/cm², this suggests a maximum temperature range of 40.7 °C ≤ T_{evap, max} ≤ 65.2 °C for the evaporators 103. A reasonable estimate for the thermal resistance of the evaporators 103 is ∼0.05 K/W, corresponding to a temperature rise of -0.5 K for the 1.33 W/cm² electronic components 203. This implies a maximum operating temperature of 40.2 °C ≤ T_{condenser} ≤ 64.7 °C for the condenser 105 if it is assumed that the electronic components 203 represent the temperature limiting components in the server board 411. These estimates suggest that the examples of the disclosure are suitable for heat reuse applications and/or thermally constrained environments. The TIM can be selected to maximise, or substantially maximise, heat transfer into the two-phase cooling system 101 as this could be a limiting factor in the performance.

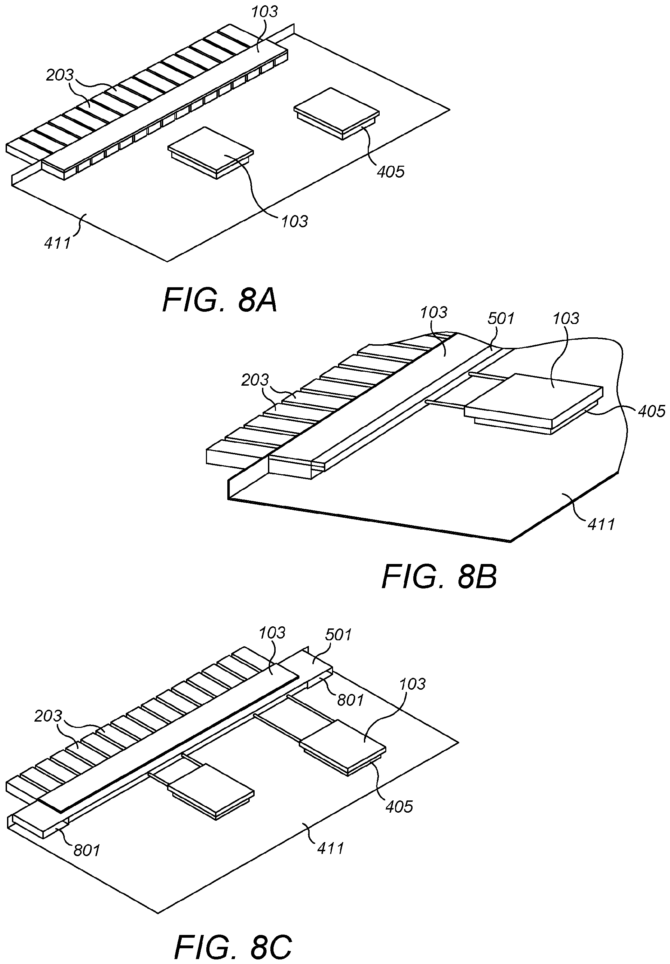

Figs. 8A to 8C show a plurality of views of parts of an example cooling system 401. In this example the two-phase cooling system 101 is configured to cool the removable electronic components 203 as well as the CPU electronic components 203.

A monolithic evaporator 103 is provided in the example of Figs. 8A to 8C. This is configured to thermally couple a plurality of electronic components 203 to the two-phase cooling system 101. The monolithic evaporator 103 is configured to be thermally coupled to a plurality of removable electronic components 203.

In the example of Figs. 8A to 8C the CPU components 405 are also coupled to an evaporator 103. This evaporator 103 is separate to the monolithic evaporator 103. This evaporator 103 is also fluidically connected to the two-phase cooling system 101.

The respective evaporators 103 are fluidically coupled to the split-level manifold 501 of the two-phase cooling system 401. This enables the working fluid 113 to be provided to the evaporators 103 and the working fluid 113 to be provided back to the split-level manifold 501. The inlet and outlet port 801 couple the split-level manifold 501 to the riser and the downcomer of the two-phase cooling system 101, as shown in Fig. 8C.

The air-cooling system 403 is not shown in Figs. 8A to 8C. It is to be appreciated that this could be provided in addition to the two-phase cooling system 101 to provide supplemental cooling.

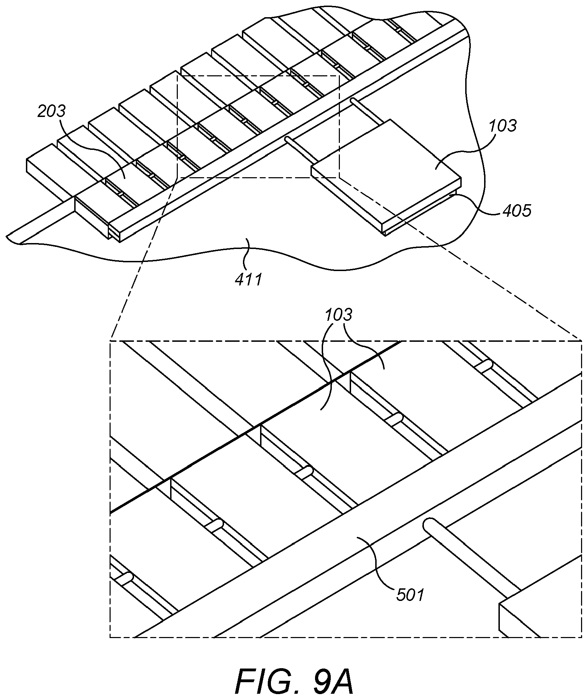

Figs. 9A to 9C show a plurality of views of parts of an example cooling system 401. In this example the two-phase cooling system 101 is also configured to cool the removable electronic components 203 as well as the CPU components 203.

In the example of Figs. 9A to 9C a plurality of evaporators 103 are provided to thermally couple a plurality of electronic components 203 to the two-phase cooling system 101.

The plurality of evaporators 103 are configured to be thermally coupled to a plurality of the removable electronic components 203.

In the example of Figs. 9A to 9C the CPU components 405 are also coupled to an evaporator 103. This evaporator 103 is separate to the monolithic evaporator 103. This evaporator 103 is also fluidically connected to the two-phase cooling system 101.

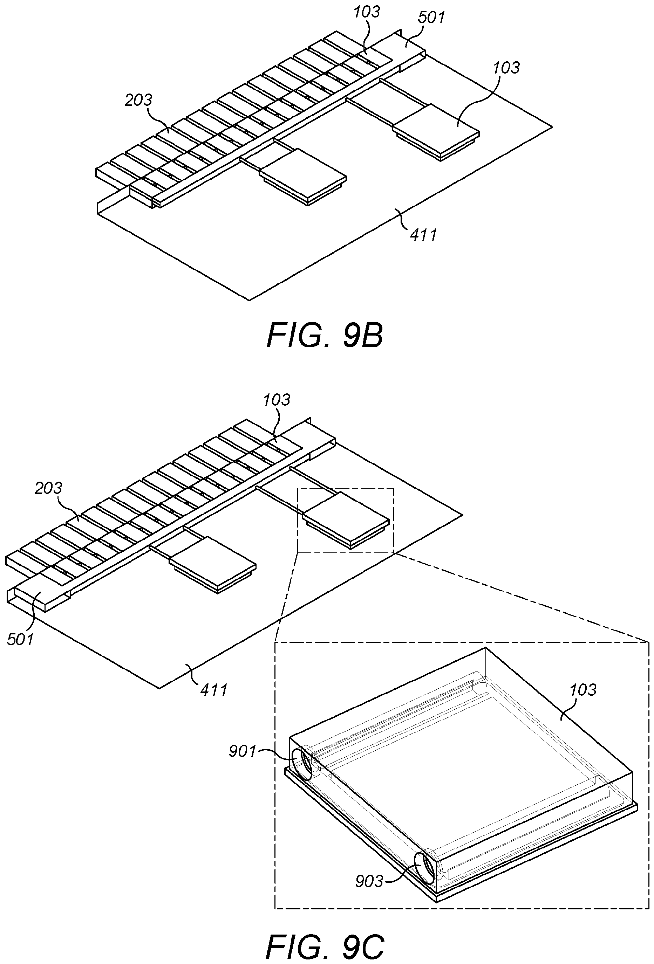

The respective evaporators 103 are fluidically coupled to the split-level manifold 501 of the two-phase cooling system 401. This enables the working fluid 113 to be provided to the evaporators 103 and the working fluid 113 to be provided back to the split-level manifold 501. Fig. 9C shows the inlet port 901 for the downcomer and the outlet port 903 for the riser of the evaporator 103 for cooling the CPU components 203.

The plurality of evaporators 103 used in the examples of Figs. 9A to 9C can be more complex to manufacture compared to the evaporators in the example shown in Figs. 8A to 8C, however the plurality of evaporators 103 can provide an improved thermal performance. As each of the evaporators 103 can be coupled to an individual electronic component 203, this can minimize, or substantially minimize, the contact thermal resistance between the evaporator 103 and the corresponding electronic component 203. In some examples a flexible tubing can be provided between the respective evaporators 103 to enable the adjustment of the positions of the evaporators 103 relative to each other and/or relative to the electronic components 203.

The air-cooling system 403 is not shown in Figs. 9A to 9C. It is to be appreciated that this could be provided in addition to the two-phase cooling system 101 to provide supplemental cooling.

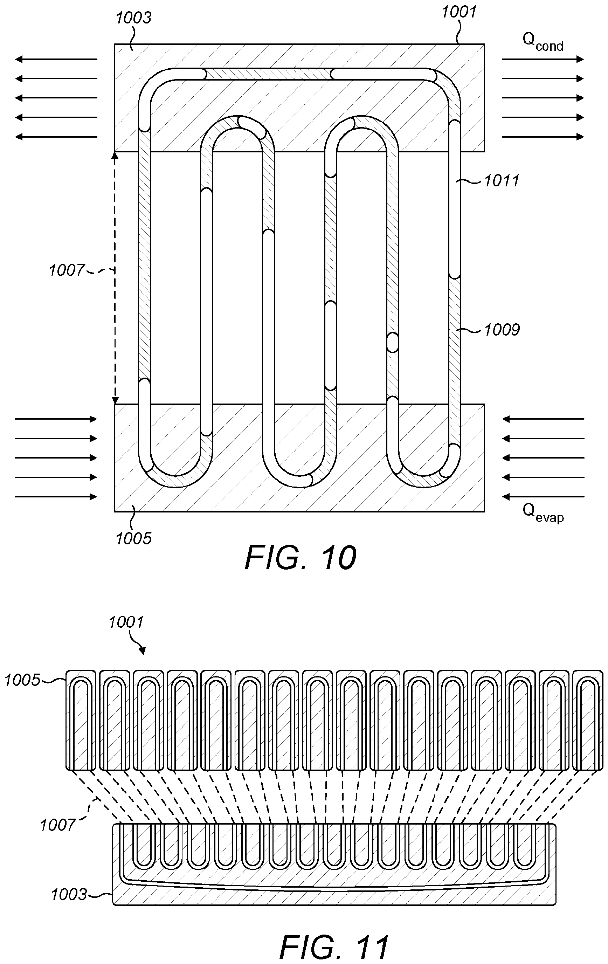

Fig. 10 schematically shows an oscillating heat pipe 1001 that can be provided within some of the cooling systems 401 of examples of the disclosure. The oscillating heat pipe 1001 comprises a condenser region 1003, an evaporator region 1005 and an adiabatic section 1007. The oscillating heat pipe 1001 can be provided as a two-phase cooling system 101 or part of a two-phase cooling system 101.

The evaporator region 1005 comprises any means for transferring heat from a heat source into working fluid within the oscillating heat pipe 1001. The evaporator region 1005 is thermally coupled to a heat source. The heat source could be an electronic component 203 that generates unwanted heat during use. For example, it could be one or more electronic components 203 and 405 within a server board 411 as shown in Figs. 8 and 9 or any other suitable type of components.

The condenser region 1003 comprises any means for transferring heat out of the working fluid within the oscillating heat pipe 1001. The condenser region 1003 is thermally coupled to a heat sink or any other suitable type of means for transferring heat out of the working fluid.

The oscillating heat pipe 1001 is configured in a meandering or serpentine configuration comprising a plurality of bends. A first plurality of bends are located in the evaporator region 1005 and a second plurality of bends are located in the condenser region 1003. In the example shown in Fig. 10 three U-shaped bends are shown in the evaporator region 1005 and two U-shaped bends are shown in the condenser region 1003. Other configurations and numbers of bends could be used in other examples of the disclosure. The meandering or serpentine configuration is configured so that the working fluid within the oscillating heat pipe 1001 is alternately heated in the evaporator region 1005 and cooled in the condenser region 1003 of the oscillating heat pipe 1001.

In the example shown in Fig. 10 the oscillating heat pipe 1001 forms a closed loop. Other types of oscillating heat pipe 1001 could be used in other examples of the disclosure.

In the example shown in Fig. 10 an adiabatic section 1007 is provided between the evaporator region 1005 and the condenser region 1003. The adiabatic section 1007 extends between the bends in the condenser region 1003 and the bends in the evaporator region 1005. The adiabatic section 1007 ensures that heat that is transferred into the working fluid in the evaporator region 1005 is retained within the oscillating heat pipe 1001 until the working fluid reaches the condenser region 1003. In some examples the oscillating heat pipe 1001 does not comprise an adiabatic section 1007. Whether or not the oscillating heat pipe 1001 comprises an adiabatic section 1007 can depend on the application and system geometry of the oscillating heat pipe 1001 and any other suitable factors.

When the oscillating heat pipe 1001 is in use, heat is applied to the working fluid in the bends within the evaporator region 1005. This heat causes, at least some of, the working fluid to evaporate. This evaporation results in an increase of vapour pressure inside the oscillating heat pipe 1001 which causes the growth of bubbles within the evaporator region 1005. The growth of the bubbles and the increase in vapour pressure forces liquid slugs 1009 of the working fluid towards the condenser region 1003. The working fluid that is pushed to the condenser region 1003 is then cooled by the condenser. This cooling reduces the vapour pressure within the working fluid and causes condensation of the bubbles and provides a restoring force that pushes the working fluid back towards the evaporator region 1005. This process of alternate bubble growth and condensation causes oscillation of the working fluid within the oscillating heat pipe 1001 and allows for the transfer of heat between the evaporator region 1005 and the condenser region 1003.

FIG. 11 shows an oscillating heat pipe 1001 that could be comprised within the two-phase cooling systems 101 in examples of the disclosure. The oscillating heat pipe 1001 could be used to cool the electronic components 203 such as the removable electronic components 203 within a server board 411. This could be used within the examples shown in Figs. 8A to 9C or in any other suitable examples.

In examples where the oscillating heat pipe 1001 is used the evaporator region 1005 can be thermally coupled to the electronic components 203. The evaporator region 1005 can be configured so that different sections or bends of the evaporator region 1005 are thermally coupled to different electronic components 203. For example, the different sections of the evaporator region 1005 could provide the rider evaporators similar to those shown in Fig. 6.

The adiabatic section 1007 can comprise a flexible tubing array that can enable the positions of the evaporator region 1005 to be adjusted relative to the positions of the condenser regions 1007. The flexible tubing could be made of any suitable flexible material such as a polymer or a composite of polymeric and metallic materials.

The condenser region 1007 can be coupled to any means for removing heat from the oscillating heat pipe 1001. In some examples the condenser region can be coupled to the evaporator of another two-phase cooling system 101 such as a thermosyphon loop. This can provide for a cooling system 401 comprising a cascade of two-phase cooling systems 101.

The use of the oscillating heat pipe 1001 with the flexible tubing portions can allow for variations in manufacturing tolerances to be accounted for. This can enable the evaporator region 1005 to be in good thermal contact with the respective electronic components 203 even when there are variations in the server board 411 and the electronic components 203 themselves.

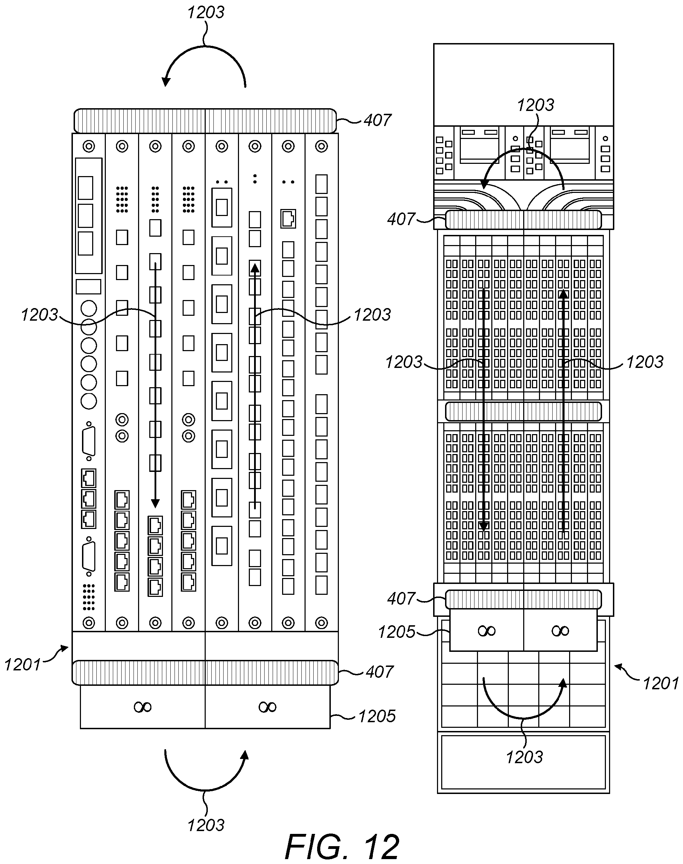

Fig. 12 shows example server racks 1201 according to examples of the disclosure. Fig. 12 show two side on views of different server racks 1201 that could be cooled using the example cooling systems 401 described herein. The server racks 1201 can comprise a plurality of server boards 411 which can be as described in any of the previous examples. The server boards 411 can be provided in a vertical arrangement.

In this example the air-cooling system 403 is configured to recirculate the air at the rack-level so that the same air is circulated through a plurality of different server boards 411 within the same rack 1201.

The heat exchangers 407 for the air-cooling system 403 are provided at the top and the bottom of a plurality of server boards 411. In this example the heat exchanger can comprise air-to refrigerant evaporators. This can enable heat to be transferred from the air to a refrigerant in a secondary cooling system.

The air can be circulated so that it flows upwards in one side of the server rack 1201 and downwards in the other side of the server rack 1201 as indicated by the arrows 1203 shown in Fig. 12.

In the examples of Figs. 12 the server racks 1201 comprise fans 1205. The fans 1205 provide recirculation means for enabling the air to be recirculated through the server racks 1201. This can prevent the air from being expelled into the area around the server rack 1201 and causing unwanted heating of the area around the server rack 1201 thus not interfering from thermal management point of view with equipment housing space such as data center, telecommunication equipment room, or network, a communication room, a computer room, a network room, indoor or outdoor deployed cabinet/s or any other suitable arrangement. In the example of Fig. 12 the fans 1205 are provided at the bottom of the server racks 1201. Other configurations of the fans 1205 could be used in other examples of the disclosure.

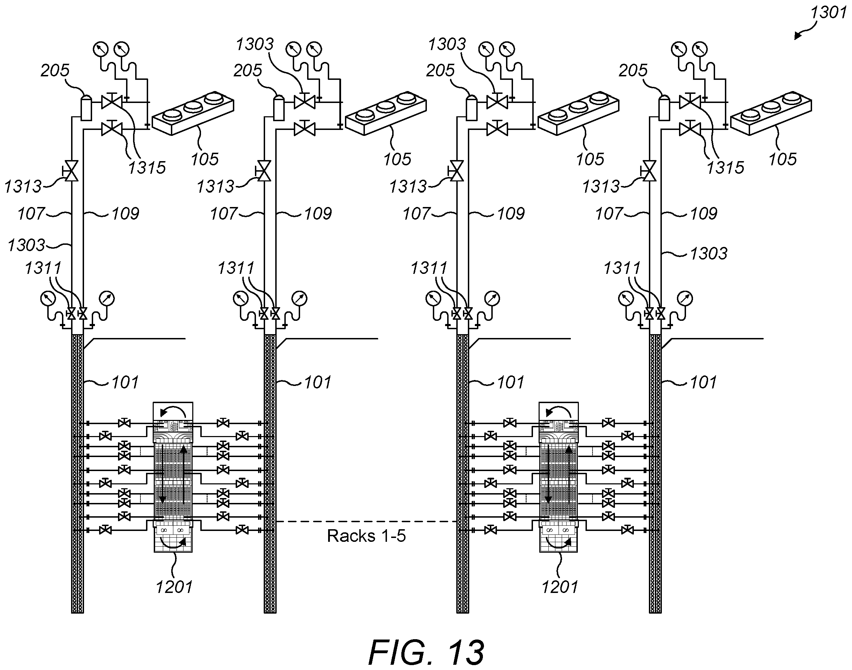

Fig. 13 shows a system 1301 for cooling a plurality of server racks 1201. The system 1301 shown in Fig. 13 uses air-cooled condensers for a secondary cooling system 1303 for cooling the two-phase cooling systems 101 and could be used for smaller data centres of up to around five server racks 1201.

The system 1301 comprises a plurality of two-phase cooling systems 101. The two-phase cooling systems 101 can be as described herein and can comprise a plurality of evaporators 103 configured to cool a plurality of electronic devices 203 within each of the server racks 1201. The two-phase cooling systems 101 could be part of a cascade of two-phase cooling systems 101 so that a first two-phase cooling system 101 is configured to provided cooling at the server board 411 and this is then coupled to a secondary two-phase cooling systems 101 to provide cooling at the server rack 1201 level.

The server rack 1201 level two-phase cooling systems101 are isolated from each other such that no fluid path is provided between two-phase cooling systems 101. As shown in Fig. 13 a plurality of two-phase cooling systems101 can be thermally coupled to a single server rack 1201 so as to enable a first two-phase cooling system 101 to be used to cool the server rack 1201 independently of a second two-phase cooling system 101.

Each of the two-phase cooling system 101 comprises a downcomer 107 and a riser 109. The two-phase cooling systems 101 are independent of each of other so that working fluid 113 that flows in one of the two-phase cooling systems 101 does not flow into any other two-phase cooling system 101. There is no fluid path provided between the two-phase cooling systems 101.

In the example shown in Fig. 13 valves 1315 are provided within the two-phase cooling systems 101 at the inlet and the outlet of the evaporator 103. These valves 1315 can enable the fluid flow to the evaporator 103 to be closed which can enable the evaporator 103 to be removed from the two-phase cooling system 101. The evaporator 103 could be removed for maintenance purposes or any other suitable reason.

In the example shown in Fig. 13 each of the server racks 1201 are thermally coupled to at least two independent two-phase cooling systems 101. The independent two-phase cooling systems 101 are identical to each other so as to enable the total amount (equivalent) of heat to be transferred by any of the two-phase cooling systems 101. This can enable the server rack 1201 to be cooled effectively by any of the available two-phase cooling systems 101. This arrangement enables one of the two-phase cooling systems 101 to be closed for maintenance or could enable an auxiliary two-phase cooling system 101 to be used if a primary two-phase cooling system 101 fails. This can enable the server racks 1201 to run continuously on the cooling system 1301 without any break for maintenance and / or in case of failure of one of the two-phase cooling systems 101.

The valves 1311 on the downcomer 107 and riser 109 can enable evaporators 103 and the two-phase cooling systems 101 to be controlled. This can enable the two-phase cooling systems 101 to be switched while the server racks 1201 are in operation which allows of continuous use of the server racks 1201 even while the two-phase cooling system 101 is being maintained.

In the example of Fig. 13 each of the two-phase cooling systems 101 also comprises a valve 1313 provided in the downcomer 107 between the accumulator 205 and the valves 1311. This valve 1313 is an on / off valve that is always open when the two-phase cooling system 101 is in use but can be closed to allow for maintenance of the two-phase cooling system 101.

In the example shown in Fig. 13 the system 1301 comprises an air-cooled condenser 105. Other types of condenser 105 could be used in other examples of the disclosure. For example, if a larger number of server racks 1201 are to be cooled then the condenser 105 can be coupled a water-cooled cooling system or another two-phase cooling system 101 or any other suitable type of heat removal system.

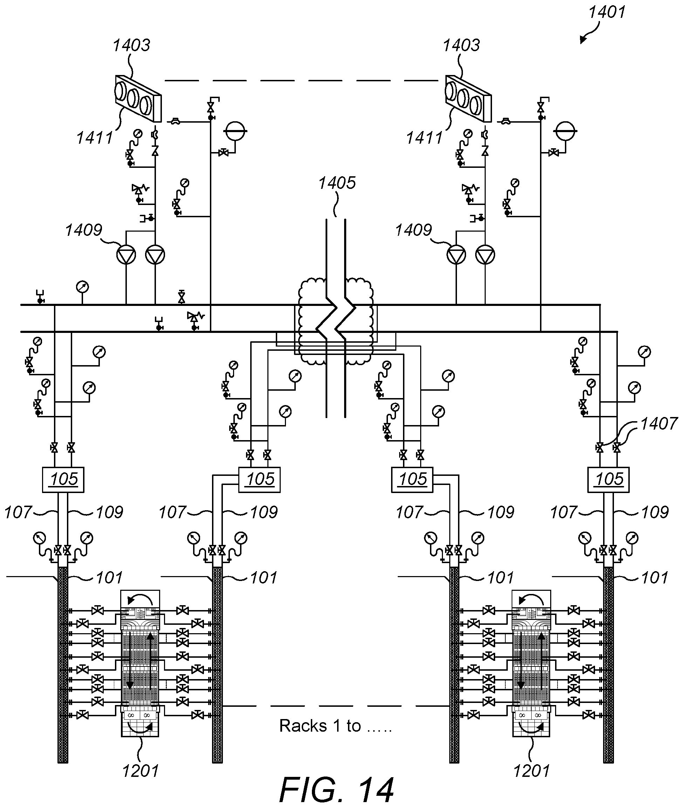

Fig. 14 schematically shows another system 1401 for cooling a plurality of server racks 1201. Each of the server racks 1201 could comprise a plurality of server boards 411 which can be configured as described herein. The system 1401 shown in Fig. 14 uses a plurality of water-cooling systems 1403 for the secondary cooling system and could be used for larger data centres comprising more than five server racks 1203.

The example system 1401 shown in Fig. 14 comprises a plurality two-phase cooling system 101. The two-phase cooling systems 101 in the system 1401 of Fig. 14 can be similar to the two-phase cooling systems 101 shown in Fig. 13. The two-phase cooling systems 101 can comprise branches and valves that enable two-phase cooling systems 101 or parts of two-phase cooling systems 101 to be closed for maintenance or other purposes.

The system 1401 of Fig. 14 differs from the system of Fig 13 in that the condensers 105 used in the two-phase cooling system 101 in Fig. 14 comprise water cooled condensers 105. This can enable higher heat loads to be removed from the two-phase cooling system 101 and so can enable the system 1401 to be used to cool larger data centres.

In the example shown in Fig. 14 each of the two-phase cooling systems 101 are coupled to at least two water cooling systems 1403. Each water-cooling system 1403 provides an independent secondary cooling system for the two-phase cooling systems 101. The water-cooling systems 1403 are independent of each other in that water from a first water-cooling system 1403 does not flow into any other of the water-cooling systems 1403. Fig. 14 schematically shows that a path separation 1405 is provided between the different water-cooling systems 1403 so that there is no fluid flow between the different water-cooling systems 1403.

In the example shown in Fig. 14 each of the water-cooling systems 1403 is capable of removing the same heat loads from the two-phase cooling systems 101. This means that the amount of heat that can be removed from the two-phase cooling systems 101 is not dependent upon which of the water-cooling systems 1403 is used for the secondary cooling.

One or more valves 1407 can be provided within the water-cooling systems 1403. In the example of Fig. 14 the valves 1407 can be provided at the inlets and outlets of the condenser 105 of the two-phase cooling systems 101. These valves 1407 can be configured to control the flow of water to the condensers 105. These valves 1407 can enable the water-cooling system 1403 that is coupled to the two-phase cooling systems 101 to be swapped. This could be used if one of the water-cooling systems 1403 needs to be maintained or is faulty.

Each of the water-cooling systems 1403 also comprises one or more pumps 1409. The pumps 1409 can comprise any means that can be configured to pump the water through the water-cooling systems 1403. Each of the water-cooling systems 1403 has its own pumping system as the water flow in one water-cooling system 1403 is independent of the water flow in another water-cooling system 1403.

The water-cooling systems 1403 also comprise secondary condensers 1411. The secondary condensers 1411 can comprise air-cooled dry coolers or any other suitable type of condensers.

The system of Fig. 14 therefore comprises a plurality of secondary water-cooling systems 1403 configured so that each two-phase cooling system 101 can be thermally coupled to a plurality of secondary water-cooling systems 1403 so as to enable a first secondary water-cooling system 1403 to be used independently of a second secondary water-cooling system 1403.

Examples of the disclosure therefore provide for improved cooling systems that can be used to cooler server racks and other similar devices.

In this description the term coupled means operationally coupled. Any number or combination of intervening elements can exist between coupled components including no intervening elements.

The term 'comprise' is used in this document with an inclusive not an exclusive meaning. That is any reference to X comprising Y indicates that X may comprise only one Y or may comprise more than one Y. If it is intended to use 'comprise' with an exclusive meaning then it will be made clear in the context by referring to "comprising only one..." or by using "consisting".

In this description, reference has been made to various examples. The description of features or functions in relation to an example indicates that those features or functions are present in that example. The use of the term 'example' or 'for example' or 'can' or 'may' in the text denotes, whether explicitly stated or not, that such features or functions are present in at least the described example, whether described as an example or not, and that they can be, but are not necessarily, present in some of or all other examples. Thus 'example', 'for example', 'can' or 'may' refers to a particular instance in a class of examples. A property of the instance can be a property of only that instance or a property of the class or a property of a sub-class of the class that includes some but not all of the instances in the class. It is therefore implicitly disclosed that a feature described with reference to one example but not with reference to another example, can where possible be used in that other example as part of a working combination but does not necessarily have to be used in that other example.

Although examples have been described in the preceding paragraphs with reference to various examples, it should be appreciated that modifications to the examples given can be made without departing from the scope of the claims.

Features described in the preceding description may be used in combinations other than the combinations explicitly described above.

Although functions have been described with reference to certain features, those functions may be performable by other features whether described or not.

Although features have been described with reference to certain examples, those features may also be present in other examples whether described or not.

The term 'a' or 'the' is used in this document with an inclusive not an exclusive meaning. That is any reference to X comprising a/the Y indicates that X may comprise only one Y or may comprise more than one Y unless the context clearly indicates the contrary. If it is intended to use 'a' or 'the' with an exclusive meaning then it will be made clear in the context. In some circumstances the use of 'at least one' or 'one or more' may be used to emphasis an inclusive meaning but the absence of these terms should not be taken to infer any exclusive meaning.

The presence of a feature (or combination of features) in a claim is a reference to that feature or (combination of features) itself and also to features that achieve substantially the same technical effect (equivalent features). The equivalent features include, for example, features that are variants and achieve substantially the same result in substantially the same way. The equivalent features include, for example, features that perform substantially the same function, in substantially the same way to achieve substantially the same result.

In this description, reference has been made to various examples using adjectives or adjectival phrases to describe characteristics of the examples. Such a description of a characteristic in relation to an example indicates that the characteristic is present in some examples exactly as described and is present in other examples substantially as described.

Whilst endeavoring in the foregoing specification to draw attention to those features believed to be of importance it should be understood that the Applicant may seek protection via the claims in respect of any patentable feature or combination of features hereinbefore referred to and/or shown in the drawings whether or not emphasis has been placed thereon.

## Claims

1. A cooling system for cooling one or more electronic components comprising:
at least one two-phase cooling system configured to cool one or more electronic components that are thermally coupled to the at least one two-phase cooling system;
at least one air-cooling system configured to cool one or more electronic components wherein the at least one air-cooling system comprises at least one heat exchanger within the at least one air-cooling system wherein the at least one heat exchanger is coupled to a two-phase cooling system or a liquid phase cooling system; and recirculation means configured to re-circulate air through the at least one air-cooling system to the one or more electronic components.

2. An apparatus as claimed in claim 1 wherein the recirculation means comprises at least one fan configured to direct the air back into the at least one air-cooling system and prevent air from being expelled from the at least one air-cooling system.

3. An apparatus as claimed in any preceding claim wherein the at least one air-cooling system comprises one or more baffles configured to direct air from the air-cooling system toward electronic components that are not cooled by the at least one two-phase cooling system.

4. An apparatus as claimed in claim 1 or 2 wherein the air-cooling system comprises one or more baffles configured to direct air from the air-cooling system towards the at least one two-phase cooling system.

5. An apparatus as claimed in any preceding claim wherein the at least one heat exchanger within the at least one air-cooling system comprises at least one evaporator.

6. An apparatus as claimed in any preceding claim wherein the cooling system comprises a plurality of two-phase cooling systems configured in a cascading configuration to enable cooling of a plurality of electronic components.

7. An apparatus as claimed in any preceding claim wherein the at least one two-phase cooling system is configured to reject heat to a secondary cooling system.

8. An apparatus as claimed in any preceding claim comprising a monolithic evaporator configured to thermally couple a plurality of electronic components to the at least one two-phase cooling system.

9. An apparatus as claimed in any of claims 1 to 7 comprising a plurality of evaporators configured to thermally couple a plurality of electronic components to the at least one two-phase cooling system.

10. An apparatus as claimed in any preceding claim wherein the at least one two-phase cooling system comprises one or more oscillating heat pipe.

11. An apparatus as claimed in claim 10 wherein the one or more oscillating heat pipes are configured to enable heat to be transferred from one or more electronic components to another two-phase cooling system.

12. An apparatus as claimed in any preceding claim wherein the at least one two-phase cooling system comprises a thermosyphon loop.

13. An apparatus as claimed in any preceding claim wherein the plurality of electronic components are provided within a server.

14. An apparatus as claims in any preceding claim wherein the at least one electronic component configured to be cooled by the at least one two-phase cooling system is configured to be removably connected to the server.

15. An apparatus as claimed in any preceding claim wherein the plurality of electronic components comprise one or more optoelectronic components.
